(19) Europäisches Patentamt
European Patent Office
Office européen des brevets

(11) **EP 4 682 942 A1**

(12) **EUROPEAN PATENT APPLICATION**
published in accordance with Art. 153(4) EPC

(43) Date of publication:
**21.01.2026 Bulletin 2026/04**

(21) Application number: 25762064.1

(22) Date of filing: **28.02.2025**

(51) International Patent Classification (IPC):
**H01L 21/3065** (2006.01)    **H01L 21/768** (2006.01)
**H01L 21/3205** (2006.01)    **H01L 23/522** (2006.01)

(52) Cooperative Patent Classification (CPC):
**H01L 21/3065; H01L 21/3205; H01L 21/768;**
**H01L 23/522**

(86) International application number:
**PCT/JP2025/007085**

(87) International publication number:
**WO 2025/183152 (04.09.2025 Gazette 2025/36)**

(84) Designated Contracting States:
**AL AT BE BG CH CY CZ DE DK EE ES FI FR GB**
**GR HR HU IE IS IT LI LT LU LV MC ME MK MT NL**
**NO PL PT RO RS SE SI SK SM TR**
Designated Extension States:
**BA**
Designated Validation States:
**GE KH MA MD TN**

(30) Priority: **01.03.2024 JP 2024031331**

(71) Applicant: **Daikin Industries, Ltd.**
**Osaka-shi, Osaka 530-0001 (JP)**

(72) Inventors:
• **TAKAKURA, Yohei**
**Osaka-Shi, Osaka 530-0001 (JP)**
• **HAYASHI, Hisataka**
**Osaka-Shi, Osaka 530-0001 (JP)**
• **NOJIRI, Yasuhiro**
**Osaka-Shi, Osaka 530-0001 (JP)**
• **SHIMOSUKI, Takumi**
**Osaka-Shi, Osaka 530-0001 (JP)**
• **NAKAMURA, Hiroki**
**Osaka-Shi, Osaka 530-0001 (JP)**
• **YAMAMOTO, Suzuka**
**Osaka-Shi, Osaka 530-0001 (JP)**

(74) Representative: **Hoffmann Eitle**
**Patent- und Rechtsanwälte PartmbB**
**Arabellastraße 30**
**81925 München (DE)**

(54) **DEPOSITION GAS**

(57) An object of the present disclosure is to newly provide a deposition gas. Deposition gas.

Fig. 1

Fig. 1: Etching Resistance of Deposition Film

EP 4 682 942 A1

**Description**

Technical Field

The present disclosure relates to deposition gases.

Background Art

PTL 1 discloses a plasma treatment gas, which is a mixture gas of $C_4F_8$ and 2,3,3,3-tetrafluoropropene.

Citation List

Patent Literature

PTL 1: WO2022/074708A1

Summary of Invention

Technical Problem

An object of the present disclosure is to newly provide a deposition gas containing a hydrofluoroethylene.

Solution to Problem

The present disclosure includes the following subject matter.

Item 1. A deposition gas comprising a hydrofluoroethylene.
Item 2. The deposition gas according to Item 1, wherein the hydrofluoroethylene is a difluoroethylene.
Item 3. The deposition gas according to Item 1, which is for use in deposition in plasma treatment in the production of a substrate including a through-silicon via (TSV).
Item 4. The deposition gas according to Item 1, which is for use in deposition in a Bosch process in the production of a substrate including a through-silicon via (TSV).
Item 5. A method for performing deposition on a substrate for producing a semiconductor using the deposition gas of Item 1.
Item 6. The method according to Item 5, wherein the substrate includes a through-silicon via (TSV), and deposition of plasma treatment is performed using the deposition gas of Item 1.
Item 7. The method according to Item 5, wherein the substrate includes a through-silicon via (TSV), and deposition is performed in a Bosch process using the deposition gas of Item 1.
Item 8.
A method for performing deposition on a substrate for producing a semiconductor, comprising adjusting a deposition rate (DR) using the deposition gas of Item 1 under conditions that satisfy the following formulas:

(1) for area density of source power: $W/cm^2$,

$$\text{deposition rate (DR)} = -6.8*10^{14}*x^2 +1.5*10^9*x$$

(2) for volume density of source power: $W/cm^3$,

$$\text{deposition rate (DR)} = -6.6*10^{19}*x^2 +4.7*10^{11}*x$$

wherein x = (relative strength of deposition gas) * (source power density squared),

the relative strength (relative intensity) is determined by dividing a radical strength (radical intensity) of desired m/z measured using a quadrupole mass spectrometer (QMS) by the sum of radical strengths (radical intensity) of mass numbers in the range of $1 \leq m/z \leq 150$ (2.5 times the molecular weight of the deposition gas), the radical strength (radical intensity) is calculated by multiplying the measurement strength of each mass number (m/z) by $\sqrt{m}$:

```
radical strength = (measurement strength of each mass
number (m/z)) * (√m),
```

thereby correcting mass dependence of measurement sensitivity of the QMS,
m represents a molecular weight,
z represents a charge state of a particle ionized in the QMS,
in the source power density, the source power represents an inductively coupled plasma (ICP) power (unit: W) during deposition:

(1) source power area density (unit: $W/cm^2$),
(2) source power volume density (unit: $W/cm^3$),

relative strength of $CH_2=CF_2$ (m/z=64) * (source power density squared),

(1) area of plasma generation dielectric window: 2,640 $cm^2$,
(2) volume of plasma generation region: 46,600 $cm^3$.

Item 9. The method according to Item 8, wherein

in the x = (relative strength of deposition gas) * (source power density squared),
the range of x is $4.0*10^{-7} \leq x \leq 2.0*10^{-6}$ when the source power density is represented by (1) source power area density (unit: $W/cm^2$), or
the range of x is $1.3*10^{-9} \leq x \leq 6.0*10^{-9}$ when the source power density is represented by (2) source power volume density (unit: $W/cm^3$).

Item 10. A semiconductor production apparatus comprising a gas ejection port for the deposition gas of Item 1.
Item 11. A method for producing a semiconductor, comprising performing deposition on a substrate for producing a semiconductor using the deposition gas of Item 1.
Item 12. Use of the deposition gas of Item 1 in the production of a semiconductor, wherein deposition is performed on a substrate for producing a semiconductor.

Advantageous Effects of Invention

The present disclosure newly provides a deposition gas containing a hydrofluoroethylene.

Brief Description of Drawings

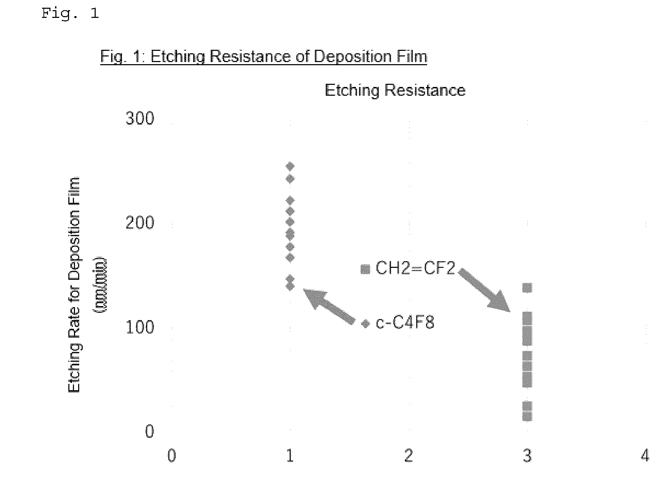

Fig. 1 is a diagram showing the evaluation of etching resistance of deposition films. A slower etching rate of a deposition film indicates a higher level of etching resistance, which is desirable. ■: 1,1-difluoroethylene ($CH_2=CF_2$) ♦: $c-C_4F_8$

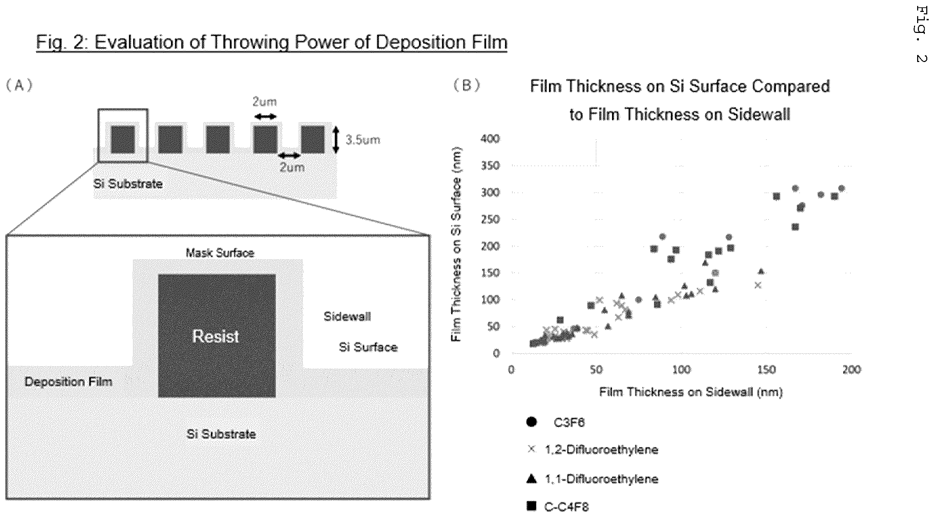

Fig. 2 is a diagram showing the evaluation of throwing power of deposition films. Fig. 2 (A): plasma treatment with various gases was performed on 2 $\mu$m lines and 2 $\mu$m spaces (3.5 $\mu$m resist/Si substrate), and the film thickness was measured on the mask surface, sidewalls, and Si surface. Fig. 2 (B) is a graph showing the film thickness on the Si surface compared to that on the sidewall. Horizontal axis: film thickness on the side walls (nm), Vertical axis: film thickness on the Si surface (nm), Line with intercept 0, •: $C_3F_6$, ✕: 1,2-difluoroethylene, ▲: 1,1-difluoroethylene, ■: $c-C_4F_8$

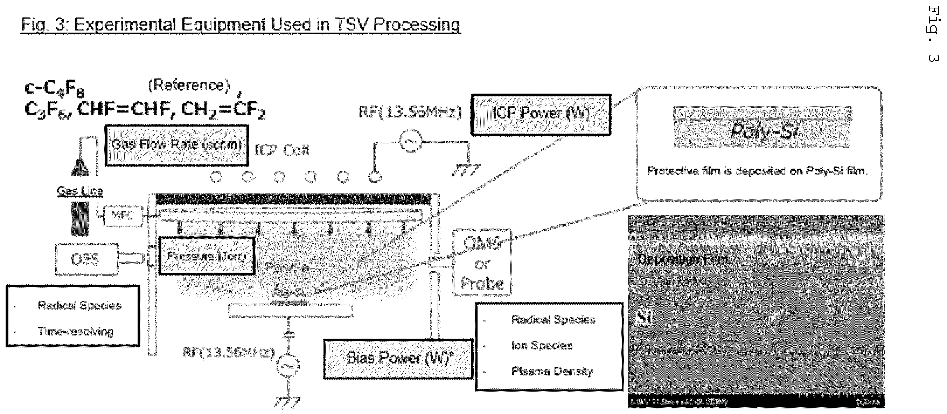

Fig. 3 shows experimental equipment used in TSV processing. The experimental equipment parameters (variables) such as ICP power, process pressure, bias power, and gas flow rate were selected. Under these conditions, a protective film was deposited on a Poly-Si film using the experimental equipment, and data (deposition rate (DR)) was collected.

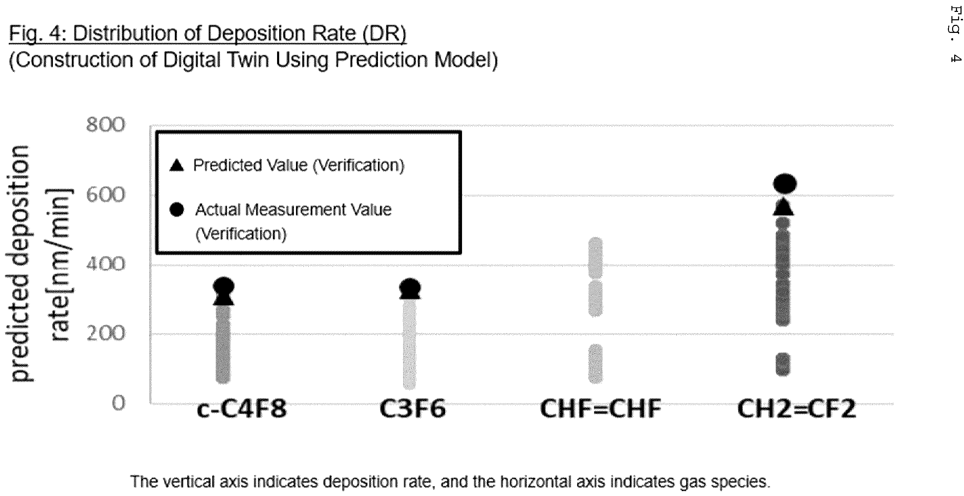

Fig. 4 is a diagram showing the distribution of deposition rate (DR) calculated by constructing a digital twin using a prediction model. The vertical axis represents the deposition rate, and the horizontal axis represents the gas species. Virtual experiment results were verified using actual experimental equipment, and they revealed that alternative gas candidates CHF=CHF and $CH_2=CF_2$ have higher deposition rates compared to $c-C_4F_8$ and $C_3F_6$. The maximum deposition rates (DR) were in the following order: $CH_2=CF_2 > CHF=CFH > C_3F_6 \approx c-C_4F_8$. In the maximum DR, $CH_2=CF_2$ and CHF=CFH were superior to $c-C_4F_8$.

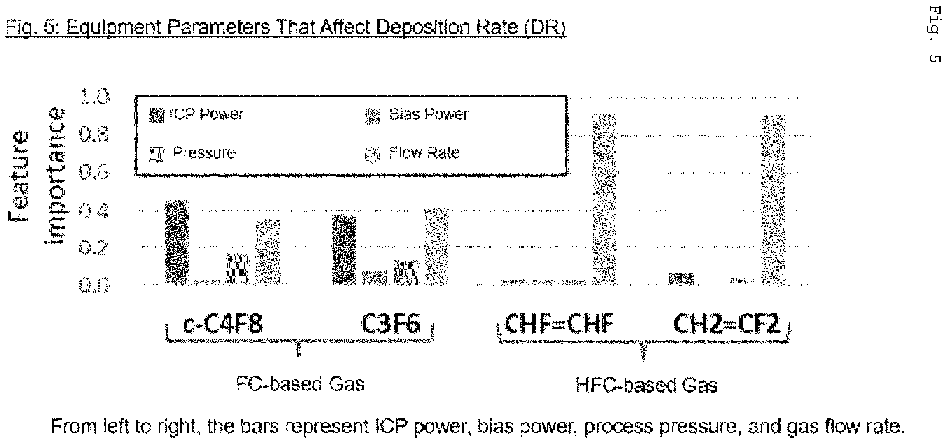

Fig. 5 is a diagram showing that the equipment parameters affecting the deposition rate (DR) differ depending on gas species. Of the equipment parameters, those affecting the deposition rate (DR) were ICP power and gas flow rate in FC-based gases, and gas flow rate for HFC-based gases.

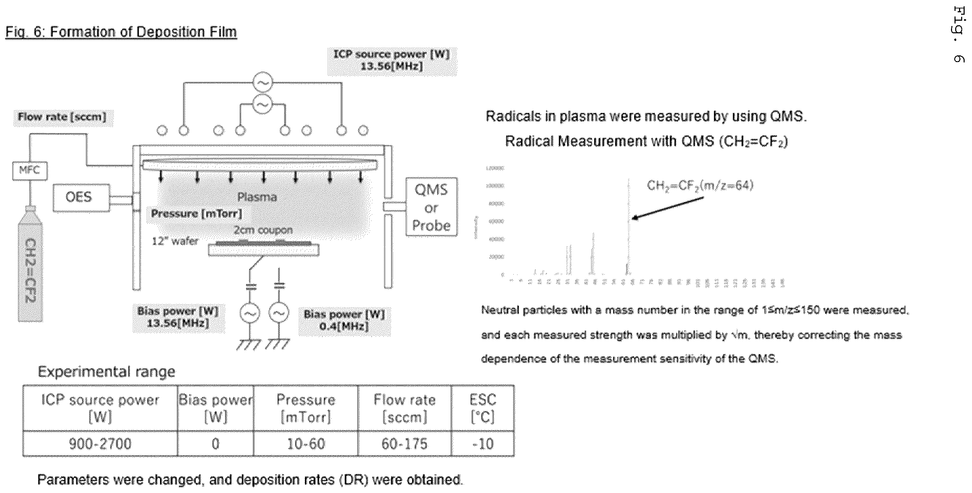

Fig. 6 is a diagram showing an experiment of deposition film formation. An EQP with a quadrupole mass spectrometer (QMS) manufactured by Hiden Analytical, mounted on the side wall of the experimental equipment, was used to measure the radicals (neutral particles) in $CH_2=CF_2$ plasma. The measurement with a QMS at this time was performed in RGA mode, applying a positive voltage to prevent positive ion influx into the QMS, and to capture only neutral particles through an orifice with a diameter of 100 $\mu$m. Electrons accelerated at 70 eV were allowed to collide with the captured neutral particles to ionize the particles, and the amount of the ionized particles was measured for each mass number (m/z). m represents the mass number of the measured neutral particles. z represents the charge state of ionized particles. The experimental equipment parameters (variables) such as ICP power (900 W to 2700 W), process pressure (10 mTorr to 60 mTorr), bias power (0 W), gas flow rate (60 sccm to 175 sccm), and electrostatic chuck (ESC, -10°C) were selected, and a deposition film was deposited on a Poly-Si film using the experimental equipment under these conditions, followed by collecting the deposition rate (DR). Radicals with mass numbers in the range of $1 \leq m/z \leq 150$ (2.5 times the molecular weight of the deposition gas) were measured using a QMS. The obtained, measured strength for each mass number (m/z) was multiplied by $\sqrt{m}$, thereby correcting the mass number dependence of the measurement sensitivity in the QMS.

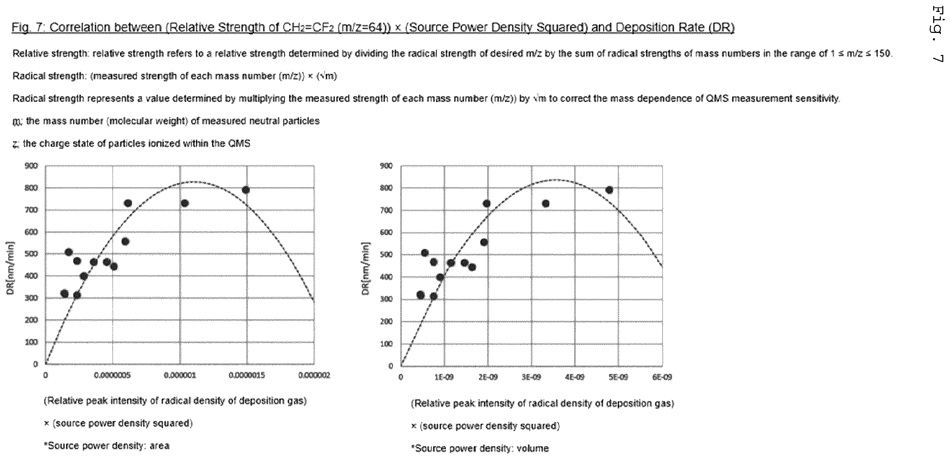

Fig. 7 is a diagram showing the correlation between (relative strength of $CH_2=CF_2$ (m/z=64)) * (source power density squared) in the horizontal axis and deposition rate (DR) in the vertical axis. The relative strength (relative intensity) is determined by dividing the radical strength (radical intensity) of desired m/z by the sum of radical strengths (radical intensity) of mass numbers in the range of $1 \leq m/z \leq 150$. The radical strength (radical intensity) is a value determined by multiplying the measurement strength of each mass number (m/z) by $\sqrt{m}$, as shown in (measurement strength of each mass number (m/z)) * ($\sqrt{m}$) to correct the mass dependence of QMS measurement sensitivity. Horizontal axis: (relative strength (relative intensity) of $CH_2=CF_2$ (m/z=64)) * (source power density squared). Vertical axis: deposition rate (DR) (nm/min). Source power: inductively coupled plasma (ICP) power during deposition.

Description of Embodiments

In the present specification, the term "comprising" includes the concepts of comprising, consisting essentially of, and consisting of. In the present specification, a numerical range indicated as "A to B" means A or more and B or less. In the present specification, units such as parts and % represent parts by mass, parts by weight, mass%, or weight% (wt%).

1. Deposition Gas

Among the microfabrication and high integration technologies of semiconductor devices, three-dimensional integration technologies that achieve integration, as represented by chiplets and other similar approaches, are attracting attention and have been implemented. A chiplet is a new design technique that aims to improve performance by dividing a single large integrated circuit (IC) into multiple smaller modules (i.e., chiplets), and then highly integrating and packaging them. Three-dimensional integration technologies refer to techniques that stack transistors and other components vertically to increase the integration density of a semiconductor device.

A typical three-dimensional integration technology is through-silicon via technology (TSV or TSV processing), which involves vertical integration processing in silicon substrates, and is widely used in semiconductor device development. TSV is a technology that creates electrodes by drilling thin vertical holes (vias) through a Si substrate and filling them with metal to connect semiconductor chips. To achieve TSV, etching with a width of several micrometers to tens of micrometers and a depth of tens of micrometers to hundreds of micrometers is required (deep etching).

Deep etching is the process of etching a substrate such as Si with a high aspect ratio.

For deep etching, a method known as the Bosch process is primarily used. The Bosch process is a plasma treatment method that repeats the following treatments in sequence: an etching treatment of etching a substrate using plasma of an etching gas, a deposition treatment ((sidewall) protective-film formation) of forming a protective film on the recesses formed by the etching treatment by using plasma of a protective-film-forming gas (deposition gas), and a treatment of exposing the etched surface (the surface to be etched) by plasma treatment.

In the traditional Bosch process, the microfabrication process poses a high environmental impact, using gases with high global warming potential (GWP), such as $c-C_4F_8$ (GWP: 10,300), $CF_4$ (GWP: 7,390), $SF_6$ (GWP: 24,300), $CHF_3$

(GWP: 14,800), and $CH_2F_2$ (GWP: 675).

The traditional Bosch process requires frequent switching of gases according to each treatment, thus decreasing the productivity of semiconductor chips. The traditional Bosch process can deteriorate the electrical characteristics of semiconductor chips due to the process-dependent surface patterns (scallops: pointed indentations that remain as non-etched portions on the etched surface).

Thus, plasma treatment methods (non-Bosch process) that perform etching and deposition simultaneously, unlike the Bosch process, have been proposed.

Traditional non-Bosch processes also use c-$C_4F_8$ and $SF_6$, which are gases with high GWP. Thus, traditional non-Bosch processes are also environmentally high-impact processes.

The present disclosure encompasses a deposition gas containing a hydrofluoroethylene used for deposition on a substrate for producing a semiconductor during semiconductor production.

A deposition gas is used for thin film deposition in processes such as chemical vapor deposition (CVD) and physical vapor deposition (PVD) in thin film production or semiconductor production.

Hydrofluoroethylene

The deposition gas of the present disclosure can perform deposition in both the Bosch and non-Bosch processes in an excellent manner on a substrate for producing semiconductors by using a hydrofluoroethylene, which is a low-GWP gas.

In the deposition gas of the present disclosure, the hydrofluoroethylene for use is preferably at least one hydrofluoroethylene selected from the group consisting of difluoroethylene and 1,1,2-trifluoroethylene (HFO-1123), and more preferably difluoroethylene.

Difluoroethylenes include 1,1-difluoroethylene (HFO-1132a), trans-1,2-difluoroethylene (HFO-1132(E), GWP: 0.0036), and cis-1,2-difluoroethylene (HFO-1132(Z)).

The deposition gas of the present disclosure for use may be a single type of hydrofluoroethylene or a combination (blend) of two or more types.

The deposition gas of the present disclosure contains a fluoroethylene. From the viewpoint of deposition rate (DR), the deposition gas of the present disclosure contains a fluoroethylene in an amount of preferably 1 volume% to 99 volume%, more preferably 10 volume% to 90 volume%, based on the total amount of the deposition gas taken as 100 volume%.

Other Deposition Gases

From the viewpoint of deposition rate (DR) and adhesion in semiconductor device production, the deposition gas of the present disclosure may contain other deposition gases, including hydrofluorocarbon compounds (HFCs), such as $CH_2F_2$, $C_2H_4F_2$, and $C_3H_2F_4$; perfluorocarbon compounds (PFCs), such as $CF_4$, $C_2F_6$, $C_3F_8$, $C_4F_8$, $C_3F_6$, $C_4F_6$, and $C_5F_8$; and iodides, such as $CF_3I$, $C_2F_5I$, and $C_3F_7I$.

The deposition gas of the present disclosure may contain other deposition gases singly or in a combination (blend) of two or more types.

Inert Gas

The deposition gas of the present disclosure may contain an inert gas as needed from the viewpoint of deposition rate (DR). The inert gas may be one or more types such as noble gases and nitrogen. Noble gases include helium, neon, argon, xenon, and krypton, with argon being preferably used. These inert gases may be used singly or in a combination (blend) of two or more types.

Deposition Gas

The deposition gas of the present disclosure has a high deposition rate (DR) for substrates for producing semiconductors.

Due to the use of the Bosch process in plasma treatment, the deposition gas of the present disclosure has a high deposition rate (DR), offers a high level of film resistance, and functions in the form of a thin film on substrates for producing semiconductors such as Si, whereas the film can be easily removed, thereby leading to increased productivity in semiconductor substrate production.

In deposition on substrates for producing semiconductors according to the Bosch process, a protective film is also deposited on top of the material to be etched. If the protective film is highly resistant to etching, the protective film cannot be removed by plasma treatment, resulting in stalled etching.

The deposition gas of the present disclosure forms a deposition film with a high level of film resistance through deposition (plasma treatment). However, as explained in the Examples of the present specification, the protective film formed using the deposition gas of the present disclosure can be removed using etching gas $SF_6$ under conditions in which bias is applied, and functions well as a deposition gas for the Bosch process.

The deposition gas of the present disclosure is preferably a deposition gas used in plasma treatment for producing a substrate with through-silicon vias (TSVs). The plasma treatment of the present disclosure includes both the Bosch and non-Bosch processes.

The deposition gas of the present disclosure is preferably a deposition gas for deposition in the Bosch process in the production of substrates with through-silicon vias (TSVs).

In the production of substrates with through-silicon vias (TSVs), use of the Bosch process and use of the deposition gas of the present disclosure in its deposition (step) enable etching of a substrate with a high aspect ratio (deep etching) in an excellent manner.

The deposition gas of the present disclosure is a low-GWP gas that, through the Bosch process, enables environmentally low-impact and sustainable microfabrication technology for substrates for producing semiconductors.

2. Method for Performing Deposition

The present disclosure encompasses a method for performing deposition using the deposition gas containing a hydrofluoroethylene (preferably difluoroethylene) of the present disclosure as a gas supplied to generate plasma for a substrate for producing semiconductors.

The method for performing deposition according to the present disclosure is preferably a method for performing deposition on a substrate with through-silicon vias (TSVs) as a substrate for producing a semiconductor using the deposition gas of the present disclosure in plasma treatment. The plasma treatment of the present disclosure includes both the Bosch processes and non-Bosch processes.

The method for performing deposition according to the present disclosure is more preferably a method for performing deposition on a substrate with through-silicon vias (TSVs) as a substrate for producing a semiconductor using the deposition gas of the present disclosure in plasma treatment according to the Bosch process.

In the production of substrates with through-silicon vias (TSVs), preferably, use of the Bosch process for plasma treatment and use of the deposition gas of the present disclosure in the deposition (step) enable etching of a substrate with a high aspect ratio (deep etching) in an excellent manner.

The present disclosure encompasses a method for performing deposition by adjusting the deposition rate (DR) using the deposition gas containing a hydrofluoroethylene (preferably difluoroethylene) of the present disclosure as a gas supplied to generate plasma for a substrate for producing semiconductors.

The radicals in the plasma generated by a deposition gas (e.g., $CH_2=CF_2$) are measured by using a quadrupole mass spectrometer (QMS).

QMS measurement conditions at this time:

Measurement mode: RGA mode (positive ion influx prevented)
Orifice size: 100 $\mu$m in diameter
Electron energy for ionizing neutral particles: 70 eV
Range of mass number measured: $1 \leq m/z \leq 150$

Experimental Equipment Parameters (Variables)

Inductively coupled plasma (ICP) Power: 900 W to 2700 W
Process pressure: 10 mTorr to 60 mTorr
Bias power: 0 W
Gas flow rate: 60 sccm to 175 sccm
Electrostatic chuck (ESC): -10°C

The experimental equipment parameters are selected. Under those conditions, the experimental equipment is used to deposit a deposition film on a Poly-Si film, and deposition rate (DR) is collected.

The radical strength (radical intensity) of mass number in the range of 2.5 times the molecular weight of the deposition gas (e.g., $CH_2=CF_2$) (for $CH_2=CF_2$, $1 \leq m/z \leq 150$) is measured. Each strength is multiplied by $\sqrt{m}$ (m: mass number of each neutral particle). The mass dependence of measurement sensitivity of the QMS is corrected by multiplying each strength by $\sqrt{m}$.

The relative strength (relative intensity) is calculated by dividing the radical strength (radical intensity) of desired m/z by the sum of radical strengths (radical intensity) of mass numbers in the range of $1 \leq m/z \leq 150$.

The radical strength (radical intensity) is corrected for mass dependence of QMS measurement sensitivity by multiplying the measurement strength of each mass number (m/z) by $\sqrt{m}$, as shown in (measurement strength of each mass number (m/z)) * ($\sqrt{m}$).

The radical strength (radical intensity) of the deposition gas can be appropriately adjusted in radical generation conditions, such as the temperature of substrates for producing semiconductors during deposition and experimental equipment parameters (ICP power, process pressure, bias power, gas flow rate, ESC, etc.).

The method for performing deposition according to the present disclosure comprises adjusting the deposition rate (DR) and performing deposition on a substrate for producing a semiconductor using the deposition gas of the present disclosure under conditions that satisfy the following formulas.

(1) For the area density of source power: W/cm$^2$,

$$\text{deposition rate (DR)} = -6.8*10^{14}*x^2 + 1.5*10^9*x$$

(2) For the volume density of source power: W/cm$^3$

$$\text{deposition rate (DR)} = -6.6*10^{19}*x^2 + 4.7*10^{11}*x$$

x = (relative strength of deposition gas) * (source power density squared)

The relative strength (relative intensity) is determined by dividing a measured radical strength (radical intensity) of desired m/z of a deposition gas by the sum of radical strengths (radical intensity) of mass numbers in the range of $1 \leq m/z \leq 150$ (2.5 times the molecular weight of the deposition gas) using a quadrupole mass spectrometer (QMS).

Radical strength: (measurement strength of each mass number (m/z)) * ($\sqrt{m}$).

The radical strength (radical intensity) is calculated by multiplying the measurement strength of each mass number (m/z) by $\sqrt{m}$, thereby correcting the mass dependence of the measurement sensitivity of the QMS.

m represents a molecular weight.
z represents a charge state of a particle ionized in the QMS.

Source Power Density

Source power: the inductively coupled plasma (ICP) power (unit: W) during deposition

(1) Source power area density (unit: W/cm$^2$)
(2) Source power volume density (unit: W/cm$^3$)

Relative strength of $CH_2=CF_2$ (m/z=64) * (source power density squared)

(1) Area of plasma generation dielectric window: 2,640 cm$^2$
(2) Volume of plasma generation region: 46,600 cm$^3$

In the method for performing deposition, the deposition rate (DR) is preferably 500 nm/min or higher.

In the following formula, x = (relative strength of deposition gas) * (source power density squared), the range of x is preferably $4.0*10^{-7}$ to $2.0*10^{-6}$ when the source power density is represented by (1) source power area density (unit: W/cm$^2$).

$$4.0*10^{-7} \leq x \leq 2.0*10^{-6}$$

In the following formula, x = (relative strength of deposition gas) * (source power density squared), the range of x is preferably $1.3*10^{-9}$ to $6.0*10^{-9}$ when the source power density is represented by (2) source power volume density (unit:

W/cm$^3$).

$$1.3*10^{-9} \leq x \leq 6.0*10^{-9}$$

The ICP power is preferably adjusted in the range of 900 W to 2700 W.

3. Semiconductor Production Apparatus

The present disclosure encompasses a semiconductor production apparatus comprising a gas ejection port for the deposition gas containing a hydrofluoroethylene of the present disclosure.

4. Method of Producing Semiconductor

The present disclosure encompasses a method for producing a semiconductor, comprising performing deposition on a substrate for producing a semiconductor by using the deposition gas containing a hydrofluoroethylene of the present disclosure.

5. Use for Semiconductor Production

The present disclosure encompasses use of the deposition gas containing a hydrofluoroethylene of the present disclosure in the production of a semiconductor, wherein deposition is performed on a substrate for producing a semiconductor.

The deposition gas of the present disclosure can preferably be applied to the Bosch process, which repeats the following treatments in sequence: an etching treatment of etching a substrate using plasma of an etching gas, a deposition treatment of forming a protective film on the recesses formed by the etching treatment by using plasma of the deposition gas of the present disclosure, and a treatment of exposing the etched surface (the surface to be etched) by plasma treatment. The deposition gas of the present disclosure has a preferable deposition rate (DR) for substrates for producing semiconductors, such as Si, leading to improved productivity of substrates for producing semiconductors.

The above describes an embodiment of the present disclosure. Various modifications in form and details can be made without departing from the spirit and scope of the claims.

Examples

The following explains the present disclosure in detail with reference to Examples and Comparative Examples. The present disclosure is not limited to only these Examples.

Plasma Treatment Method in Examples and Comparative Examples

(1) Deposition Rate (DR)

The dependence of the deposition rate (DR) on the source power, which is one of the important characteristics of deposition gases, was evaluated.

Deposition (Preparation of Deposition Film)

Deposition was performed on a silicon substrate (Si) and a silicon oxide film (SiO$_2$, TEOS) formed on a silicon substrate using an ICP (inductively coupled plasma) apparatus under the following deposition conditions: gas flow rate of 20 sccm, pressure of 10 mTorr, bias of 0 W, and source power of 100 W, 200 W, and 300 W (Table 1).

Deposition gas: 1,2-difluoroethylene (CHF=CHF)
Deposition gas: octafluorocyclobutane (c-C$_4$F$_8$)

Table 1

| Table 1: Source Power Dependence of DR on TEOS Film | | | |
|---|---|---|---|
| Source Power (W) | 100 | 200 | 300 |

(continued)

| Table 1: Source Power Dependence of DR on TEOS Film | | | |
|---|---|---|---|
| Deposition Gas | Deposition Rate (nm/min) | | |
| Example CHF=CHF | 142 | 209 | 272 |
| Comparative Example c-$C_4F_8$ | 12 | 132 | 156 |

In the Example (CHF=CHF), deposition was confirmed, and the DR was higher than that of the Comparative Example (c-$C_4F_8$). The deposition gas of the present disclosure contains a hydrofluoroethylene and is expected to reduce the processing time for deposition in plasma treatment methods, showing promise for usefulness as a deposition gas.

### (2) Sputtering Resistance

In Ar-sputtering according to X-ray photoelectron spectroscopy (XPS), the sputtering rate of a deposition film was derived, and the hardness (sputtering resistance) of the film was evaluated for a structure composed of the deposition film (deposition gas: CHF=CHF or c-$C_4F_8$), a polysilicon film (PolySi), a silicon oxide film ($SiO_2$), and a silicon substrate (Si).

### Deposition: Preparation of Deposition Film

Deposition was performed on a silicon substrate (Si) and a silicon oxide film ($SiO_2$) formed on a silicon substrate using an ICP apparatus under the following deposition conditions: gas flow rate of 70 sccm, pressure of 5 mTorr, bias of 0 W, and source power of 200 W.

### Sputtering

In the Example (deposition gas: deposition film using CHF=CHF), the deposition film was hardly scraped off even when sputtering time was increased. In the Comparative Example (deposition gas: deposition film using c-$C_4F_8$), the deposition film was scraped.

In the Example (CHF=CHF), the deposition film was harder in Ar-GCIB (gas cluster ion beam) sputtering (5 kV, 20 nA) compared to that in the Comparative Example (c-$C_4F_8$). The deposition gas of the present disclosure contains a hydrofluoroethylene and can form a deposition film with sputtering resistance in a plasma treatment method.

### (3) Etching Resistance

### Deposition Film Formation

Equipment parameters (ICP power, internal system pressure, bias power, and gas flow rate) were changed at the levels shown in Table 2 below, and deposition films were formed. The pattern was a contact hole (hole diameter: 2 $\mu$m) on a 0.5 $\mu$m TEOS mask on a Si substrate, and the resistance of the deposition film formed on the upper part (upper part of TEOS) was evaluated.

Table 2

| Table 2: Equipment Parameter | Level |
|---|---|
| ICP Power (W) | 200, 300, 400 |
| Internal System Pressure (mTom) | 5, 20, 35 |
| Bias Power (W) | 0, 50 |
| Gas Flow Rate (sccm) | 10, 35, 70 |

### Etching Resistance of Deposition Film

$SF_6$ etching processing (processing time: 35s ($C_2H_2F_2$), 60s (c-$C_4F_8$), Esc temp.: 20°C) was performed on the deposition films using an ICP apparatus. The etching rate of the deposition films was calculated from the difference between the film thickness immediately after film formation and the film thickness after etching processing (Table 3).

Table 3

| Table 3: Etching Rate of Deposition film | | | | | |
|---|---|---|---|---|---|
| ICP Power (W) | Bias Power (W) | Internal System Pressure (mTorr) | Gas Flow Rate (sccm) | Etching Rate of Deposition film (nm/min) | |
| | | | | $c\text{-}C_4F_8$ | $CH_2\text{=}CF_2$ |
| 200 | 0 | 5 | 70 | - | 94 |
| 200 | 0 | 35 | 10 | 213 | 139 |
| 200 | 0 | 35 | 35 | - | 88 |
| 200 | 0 | 35 | 70 | 168 | 96 |
| 200 | 50 | 5 | 35 | - | - |
| 200 | 50 | 20 | 35 | 147 | - |
| 200 | 50 | 35 | 35 | 141 | 52 |
| 300 | 0 | 5 | 10 | 243 | 88 |
| 300 | 0 | 5 | 70 | 189 | 74 |
| 300 | 0 | 20 | 10 | 202 | 26 |
| 300 | 0 | 35 | 10 | 178 | 110 |
| 300 | 50 | 35 | 10 | 222 | 64 |
| 400 | 0 | 5 | 10 | 192 | 54 |
| 400 | 0 | 5 | 70 | 213 | 64 |
| 400 | 0 | 20 | 10 | - | 112 |
| 400 | 0 | 35 | 10 | 255 | 98 |
| 400 | 0 | 35 | 70 | 202 | 108 |
| 400 | 50 | 5 | 10 | - | 16 |
| 400 | 50 | 35 | 70 | 189 | 48 |

Fig. 1 is a diagram showing the evaluation of etching resistance of deposition films. A slower etching rate of a deposition film indicates a higher level of etching resistance, which is desirable.

■: 1,1-difluoroethylene ($CH_2\text{=}CF_2$)
♦: $c\text{-}C_4F_8$

The Example ($CH_2\text{=}CF_2$) (■) exhibited a lower etching rate (ER), a limited loss of the deposition film, and excellent etching resistance, as compared to the Comparative Example ($c\text{-}C_4F_8$) (♦) (Table 3 and Fig. 1). The deposition gas of the present disclosure contains a hydrofluoroethylene and can form a deposition film with excellent etching resistance in a plasma treatment method.

(4) Evaluation of Throwing Power

The throwing power of deposition films was evaluated. In evaluation of throwing power, it is considered to be advantageous for Si deep etching (Bosch process) if the deposition film adheres to sidewalls but poorly adheres to the bottom surface.

Fig. 2 is a diagram showing the evaluation of throwing power of deposition films.

(A) Conditions: plasma treatment with various gases was performed on 2 $\mu$m lines and 2 $\mu$m spaces (3.5 $\mu$m resist/Si substrate), and the film thickness was measured on the mask surface, sidewalls, and Si surface.
(B) Calculation of Approximation Curve

The graph shows the film thickness on the Si surface as compared to that on the sidewalls.

Horizontal axis: film thickness on the side wall (nm)
Vertical axis: film thickness on the Si surface (nm)
Line with intercept 0
•: $C_3F_6$
×: 1,2-difluoroethylene
**A:** 1,1-difluoroethylene
■: c-$C_4F_8$

From the plots of each gas, approximate curves (linear equations) were determined. This revealed that the deposition films formed using 1,2-difluoroethylene (×) or 1,1-difluoroethylene (▲) had a gentler slope compared to the deposition films formed using c-$C_4F_8$ (■) or $C_3F_6$ (•).

Gas That Poorly Deposits on Si Surface (Bottom) Compared to on Sidewalls

The approximation curves (Fig. 2) indicate that attempting to achieve a film thickness of 100 nm with c-$C_4F_8$ (■) on the sidewalls (horizontal axis) resulted in a film with a thickness of about 190 nm (vertical axis) on the bottom surface (Si surface), whereas attempting to achieve a film thickness of 100 nm with $CH_2$=$CF_2$ (▲) on the sidewalls (horizontal axis) resulted in a film with a thickness of about 110 nm (vertical axis) on the bottom surface (Si surface). $CH_2$=$CF_2$ (▲) can form a hard-to-adhere deposition film on the bottom surface (Si surface) (i.e., a film thinly adhering to the bottom surface (Si surface)).

Hydrofluoroethylenes, such as 1,2-difluoroethylene and 1,1-difluoroethylene, were gases that have been poorly deposited on the Si surface (bottom) as compared to on sidewalls (Fig. 2 and Table 4). In the Si deep etching (Bosch process) that etches Si while protecting the sidewalls, hydrofluoroethylenes can be evaluated as forming an advantageous deposition film.

Table 4

| Inclination of Approximation Curve (Linear Equation) | |
|---|---|
| c-$C_4F_8$ Deposition Film | 1.9 |
| $C_3F_6$ Deposition Film | 1.7 |
| $C_2H_2F_2$ Deposition Film 1,2-Difluoroethylene | 1.1 |
| $C_2H_2F_2$ Deposition Film 1,1-Difluoroethylene | 1.2 |

Generally, it is preferred that the deposition film adheres thinly to the bottom surface of the recesses formed by etching treatment in Si deep etching (Bosch process). The present disclosure uses a deposition gas containing a hydrofluoroethylene, such as 1,2-difluoroethylene and 1,1-difluoroethylene, to form a deposition film. The deposition film adheres thinly to the bottom surface of the recesses formed by etching treatment, as compared to the deposition films formed by using c-$C_4F_8$ or $C_3F_6$, and is thus evaluated as being advantageous particularly in Si deep etching (Bosch process).

(5) Development of Low-GWP Gas for High-efficiency TSV Using Digital Twin

Fig. 3 shows experimental equipment used in TSV processing. The experimental equipment parameters (variables) were selected, and a protective film was deposited on a Poly-Si film, followed by collecting data (deposition rate (DR)).

A search for low-GWP gases for high-efficiency TSV was conducted using a digital twin. A digital twin refers to a virtual (but equivalent to reality in effect; another reality) object, system, or process reproduced on a computer.

A characteristic of the gas search process using a digital twin is that a comprehensive virtual experiment is performed on the digital twin based on a "prediction model" built on streamlined experiments.

First, from a chemical perspective, a search was conducted for alternative gas candidates that outperform existing c-$C_4F_8$ in terms of deposition rate, which is a performance indicator for deposition gases. Then, $C_3F_6$, CHF=CHF, and $CH_2$=$CF_2$, which all had GWP of less than 1, were selected as alternative gas candidates.

Subsequently, in order to obtain optimal parameter settings with fewer experimental trials, an experimental design method was used. The experimental design method is an application of mathematical statistics that studies efficient experimental planning and analysis methods by investigating whether effects of specific factors are present on a subject. Nineteen experimental conditions were selected for actual experimental equipment parameters (variables), including ICP power, process pressure, bias power, and gas flow rate, based on the experimental design method, and an actual experiment was then conducted under these conditions.

The experiment was conducted using experimental equipment (Fig. 3) of the same type as that for use in TSV processing in mass production. A protective film was deposited on a Poly-Si film to collect data (deposition rate (DR)).

Subsequently, a prediction model to predict the deposition rate (DR) depending on equipment parameters was constructed based on the experimental results. A digital twin that reproduces actual process conditions was constructed using this prediction model, and 490 comprehensive virtual experiments were conducted in the digital space to calculate the distribution of deposition rate (DR).

Fig. 4 is a diagram showing the distribution of deposition rate (DR) calculated by constructing the digital twin using the prediction model.

In Fig. 4, the vertical axis represents the deposition rate, and the horizontal axis represents the gas species. Virtual experiment results were verified using actual experimental equipment, and it revealed that alternative gas candidates CHF=CHF and $CH_2=CF_2$ have higher deposition rates than $c-C_4F_8$ and $C_3F_6$ (Fig. 4).

In general, a search for alternative gases uses a local optimization approach that essentially explores conditions around those used for a reference ($c-C_4F_8$ currently used as a deposition gas). Using a digital twin allowed gas exploration in a space under a wide range of conditions, and thus enabled a search for a global optimal solution while simultaneously reducing the experimental time from 245 hours to about 30 minutes.

The maximum values of deposition rate (DR) were in the following order: $CH_2=CF_2 > CHF=CFH > C_3F_6 \approx c-C_4F_8$. The maximum values of DR of $CH_2=CF_2$ and CHF=CFH were superior to those of $c-C_4F_8$ and $C_3F_6$ (Fig. 4).

Fig. 5 is a diagram showing that the equipment parameters affecting the deposition rate (DR) vary depending on gas species.

It became clear that the equipment parameters affecting the deposition rate (DR) vary depending on gas species (Fig. 5). Of the equipment parameters, those affecting the deposition rate (DR) were found to be ICP power and gas flow rate in FC-based gases, i.e., $c-C_4F_8$ and $C_3F_6$. Of the equipment parameters, a parameter affecting the deposition rate (DR) was found to be gas flow rate in HFC-based gases, i.e., CHF=CHF and $CH_2=CF_2$. Use of the digital twin technology enabled a search for low-GWP gases for high-efficiency TSV (an effect of reducing the environmental impact).

(6) Development of Deposition Method for Adjusting Deposition Rate (DR)

Fig. 6 is a diagram showing an experiment of deposition film formation.

A quadrupole mass spectrometer (QMS) was used to measure the radicals in a deposition gas ($CH_2=CF_2$) in plasma to determine ion density.

QMS measurement conditions at this time:

Measurement mode: RGA mode (positive ion influx prevented)
Orifice size: 100 μm in diameter
Electron energy for ionizing neutral particles: 70 eV
Range of mass number measured: $1 \le m/z \le 150$

The experimental equipment parameters (variables) were selected. Under those conditions, the experimental equipment was used to deposit a deposition film on a Poly-Si film, and deposition rates (DR) were collected.

Experimental Equipment Parameters (Variables)

ICP Power: 900 W to 2700 W
Process pressure: 10 mTorr to 60 mTorr
Bias power: 0 W
Gas flow rate: 60 sccm to 175 sccm
Electrostatic chuck (ESC): -10°C

The radical strength (radical intensity) of mass number in the range of 2.5 times the molecular weight of the deposition gas (e.g., $CH_2=CF_2$) (for $CH_2=CF_2$, $1 \le m/z \le 150$) was measured. Each strength was multiplied by $\sqrt{m}$ (m: molecular weight). The mass dependence of measurement sensitivity of the QMS was corrected by multiplying each strength by $\sqrt{m}$.

The relative strength (relative intensity) was calculated by dividing the radical strength (radical intensity) of desired m/z of the deposition gas by the sum of radical strengths (radical intensity) of mass numbers in the range of $1 \le m/z$

≤ 150.

**The radical** strength (radical intensity) was corrected for mass dependence of QMS measurement sensitivity by multiplying the measurement strength of each mass number (m/z) by $\sqrt{m}$, as shown in (measurement strength of each mass number (m/z)) * ($\sqrt{m}$).

The radical strength (radical intensity) of the deposition gas was appropriately adjusted in radical generation conditions, such as the temperature of substrates for producing semiconductors during deposition and experimental equipment parameters (ICP power, process pressure, bias power, gas flow rate, ESC, etc.).

As shown in Fig. 6, an EQP series with a quadrupole mass spectrometer (QMS) manufactured by Hiden Analytical, mounted on the side wall of the experimental equipment, was used to measure the radicals (neutral particles) in $CH_2=CF_2$ plasma. The measurement with a QMS at this time was performed in RGA mode, applying a positive voltage to prevent positive ion influx into the QMS, and to capture only neutral particles through an orifice with a diameter of 100 $\mu$m.

Electrons accelerated at 70 eV were allowed to collide with the captured neutral particles to ionize the particles, and the amount of the ionized particles was measured for each mass number (m/z). m represents the molecular weight of the measured neutral particles. z represents the charge state of particles ionized within the QMS.

Radicals with mass numbers in the range of $1 \le m/z \le 150$ (2.5 times the molecular weight of the deposition gas) were measured using a QMS. The obtained, measured strength for each mass number (m/z) was multiplied by $\sqrt{m}$, thereby correcting the mass number dependence of the measurement sensitivity in the QMS.

Fig. 7 is a diagram showing the correlation between (relative strength of $CH_2=CF_2$ (m/z=64)) * (source power density squared) in the horizontal axis and deposition rate (DR) in the vertical axis.

The relative strength (relative intensity) is determined by dividing the radical strength (radical intensity) of desired m/z by the sum of radical strengths (radical intensity) of mass numbers in the range of $1 \le m/z \le 150$.

The radical strength (radical intensity) is a value determined by multiplying the measurement strength of each mass number (m/z) by $\sqrt{m}$, as shown in (measurement strength of each mass number (m/z)) * ($\sqrt{m}$) to correct the mass dependence of QMS measurement sensitivity.

Horizontal axis: (relative strength of $CH_2=CF_2$ (m/z=64)) * (source power density squared)
Vertical axis: deposition rate (DR) (nm/min)
Source power: inductively coupled plasma (ICP) power during deposition

Table 5

| Table 5: Correlation between horizontal axis: (relative strength of deposition gas) * (source power density squared) and vertical axis: deposition rate (DR) (Area version) | |
| --- | --- |
| Horizontal Axis (relative strength of deposition gas ($CH_2=CF_2$)) * (source power density squared) | Vertical Axis Deposition Rate (DR) (nm/min) |
| $3.0*10^{-7}$ | 388.8 |
| $6.0*10^{-7}$ | 655.2 |
| $9.0*10^{-9}$ | 799.2 |
| $1.2*10^{-6}$ | 820.8 |
| $1.5*10^{-6}$ | 720.0 |
| $1.8*10^{-6}$ | 496.8 |

Table 6

| Table 6: Correlation between horizontal axis: (relative strength of deposition gas) * (source power density squared) and vertical axis: deposition rate (DR) (Volume version) | |
| --- | --- |
| Horizontal Axis (relative strength of deposition gas ($CH_2=CF_2$)) * (source power density squared) | Vertical Axis Deposition Rate (DR) (nm/min) |
| $1.0*10^{-9}$ | 404 |
| $2.0*10^{-9}$ | 676 |
| $3.0*10^{-9}$ | 816 |
| $4.0*10^{-9}$ | 824 |

(continued)

| Table 6: Correlation between horizontal axis: (relative strength of deposition gas) * (source power density squared) and vertical axis: deposition rate (DR) (Volume version) | |
|---|---|
| Horizontal Axis (relative strength of deposition gas ($CH_2=CF_2$)) * (source power density squared) | Vertical Axis Deposition Rate (DR) (nm/min) |
| $5.0*10^{-9}$ | 700 |
| $6.0*10^{-9}$ | 444 |

According to the experimental results, the method for performing deposition can adjust the deposition rate (DR) for a substrate for producing a semiconductor using the deposition gas under conditions that satisfy the following formulas.

(1) For the area density of source power: $W/cm^2$,

$$\texttt{deposition rate (DR)} = -6.8*10^{14}*x^2 + 1.5*10^9*x.$$

(2) For the volume density of source power: $W/cm^3$,

$$\texttt{deposition rate (DR)} = -6.6*10^{19}*x^2 + 4.7*10^{11}*x.$$

x = (relative strength of deposition gas) * (source power density squared)

The relative strength (relative intensity) is determined by dividing measured radical strength (radical intensity) of desired m/z by the sum of radical strengths (radical intensity) of mass numbers in the range of $1 \leq m/z \leq 150$ (2.5 times the molecular weight of the deposition gas) using a quadrupole mass spectrometer (QMS).

Radical strength: (measurement strength of each mass number (m/z)) * ($\sqrt{m}$)

The radical strength (radical intensity) is calculated by multiplying the measurement strength of each mass number (m/z) by $\sqrt{m}$, thereby correcting the mass dependence of the measurement sensitivity of the QMS.

m represents a molecular weight.
z represents a charge state of a particle ionized in the QMS.

Source Power Density

Source power: the inductively coupled plasma (ICP) power (unit: W) during deposition

(1) Source power area density (unit: $W/cm^2$)
(2) Source power volume density (unit: $W/cm^3$)

Relative strength of $CH_2=CF_2$ (m/z=64) * (source power density squared)

(1) Area of plasma generation dielectric window: 2,640 $cm^2$
(2) Volume of plasma generation region: 46,600 $cm^3$

In the method for performing deposition, the deposition rate (DR) is preferably 500 nm/min or higher.
The experimental results indicate that in the following formula, x = (relative strength of deposition gas) * (source power density squared), the range of x was $4.0*10^{-7}$ to $2.0*10^{-6}$ when the source power density was represented by (1) source power area density (unit: $W/cm^2$).

$$4.0*10^{-7} \leq x \leq 2.0*10^{-6}$$

The experimental results indicate that in the following formula, x = (relative strength of deposition gas) * (source power density squared), the range of x was $1.3*10^{-9}$ to $6.0*10^{-9}$ when the source power density was represented by (2) source power volume density (unit: $W/cm^3$).

$$1.3*10^{-9} \leq x \leq 6.0*10^{-9}$$

The present disclosure newly provides an environmentally low-impact deposition gas for TSV processing (low-GWP gas for high-efficiency TSV), which can significantly contribute to reducing the environmental impact as its application progresses along with the spread of three-dimensional integration technology. The present disclosure provides gases for microfabrication and high-density layering, as well as gases that prioritize environmental performance to reduce the environmental impact and use energy efficiently.

**Claims**

1. A deposition gas comprising a hydrofluoroethylene.

2. The deposition gas according to claim 1, wherein the hydrofluoroethylene is a difluoroethylene.

3. The deposition gas according to claim 1, which is for use in deposition in plasma treatment in the production of a substrate including a through-silicon via (TSV).

4. The deposition gas according to claim 1, which is for use in deposition in a Bosch process in the production of a substrate including a through-silicon via (TSV).

5. A method for performing deposition on a substrate for producing a semiconductor using the deposition gas of claim 1.

6. The method according to Item 5, wherein the substrate includes a through-silicon via (TSV), and deposition of plasma treatment is performed using the deposition gas of claim 1.

7. The method according to claim 5, wherein the substrate includes a through-silicon via (TSV), and deposition is performed in a Bosch process using the deposition gas of claim 1.

8. A method for performing deposition on a substrate for producing a semiconductor, comprising adjusting a deposition rate (DR) using the deposition gas of claim 1 under conditions that satisfy the following formulas:

    (1) for area density of source power: $W/cm^2$,

    $$deposition\ rate\ (DR) = -6.8*10^{14}*x^2 +1.5*10^9*x$$

    (2) for volume density of source power: $W/cm^3$,

    $$deposition\ rate\ (DR) = -6.6*10^{19}*x^2 +4.7*10^{11}*x$$

    wherein x = (relative strength of deposition gas) * (source power density squared),

    the relative strength is determined by dividing a radical strength of desired m/z measured using a quadrupole mass spectrometer (QMS) by the sum of radical strengths of mass numbers in the range of $1 \leq m/z \leq 150$ (2.5 times the molecular weight of the deposition gas),
    the radical strength is calculated by multiplying the measurement strength of each mass number (m/z) by $\sqrt{m}$:

    radical strength = (measurement strength of each mass number (m/z)) * $(\sqrt{m})$,

    thereby correcting mass dependence of measurement sensitivity of the QMS,
    m represents a molecular weight,

z represents a charge state of a particle ionized in the QMS,
in the source power density, the source power represents an inductively coupled plasma (ICP) power (unit: W) during deposition:

(1) source power area density (unit: $W/cm^2$),
(2) source power volume density (unit: $W/cm^3$),

relative strength of $CH_2=CF_2$ (m/z=64) * (source power density squared),

(1) area of plasma generation dielectric window: 2,640 $cm^2$,
(2) volume of plasma generation region: 46,600 $cm^3$.

9. The method according to claim 8, wherein

in the x = (relative strength of deposition gas) * (source power density squared),
the range of x is $4.0*10^{-7} \leq x \leq 2.0*10^{-6}$ when the source power density is represented by (1) source power area density (unit: $W/cm^2$), or
the range of x is $1.3*10^{-9} \leq x \leq 6.0*10^{-9}$ when the source power density is represented by (2) source power volume density (unit: $W/cm^3$).

10. A semiconductor production apparatus comprising a gas ejection port for the deposition gas of claim 1.

11. A method for producing a semiconductor, comprising performing deposition on a substrate for producing a semiconductor using the deposition gas of claim 1.

12. Use of the deposition gas of claim 1 in the production of a semiconductor, wherein deposition is performed on a substrate for producing a semiconductor.

Fig. 1

Fig. 1: Etching Resistance of Deposition Film

Fig. 2

Fig. 2: Evaluation of Throwing Power of Deposition Film

Fig. 3

EP 4 682 942 A1

Fig. 3: Experimental Equipment Used in TSV Processing

Fig. 4

Fig. 4: Distribution of Deposition Rate (DR)
(Construction of Digital Twin Using Prediction Model)

▲ Predicted Value (Verification)

● Actual Measurement Value (Verification)

predicted deposition rate[nm/min]

c-C4F8    C3F6    CHF=CHF    CH2=CF2

The vertical axis indicates deposition rate, and the horizontal axis indicates gas species.

Fig. 5

Fig. 5: Equipment Parameters That Affect Deposition Rate (DR)

From left to right, the bars represent ICP power, bias power, process pressure, and gas flow rate.

Fig. 6

EP 4 682 942 A1

## Fig. 6: Formation of Deposition Film

Radicals in plasma were measured by using QMS.

Radical Measurement with QMS ($CH_2=CF_2$)

$CH_2=CF_2 (m/z=64)$

Neutral particles with a mass number in the range of $1 \leq m/z \leq 150$ were measured, and each measured strength was multiplied by $\sqrt{m}$, thereby correcting the mass dependence of the measurement sensitivity of the QMS.

Experimental range

| ICP source power [W] | Bias power [W] | Pressure [mTorr] | Flow rate [sccm] | ESC [°C] |
|---|---|---|---|---|
| 900-2700 | 0 | 10-60 | 60-175 | -10 |

Parameters were changed, and deposition rates (DR) were obtained.

Fig. 7

Fig. 7: Correlation between (Relative Strength of $CH_2=CF_2$ (m/z=64)) × (Source Power Density Squared) and Deposition Rate (DR)

Relative strength: relative strength refers to a relative strength determined by dividing the radical strength of desired m/z by the sum of radical strengths of mass numbers in the range of $1 \leq m/z \leq 150$.

Radical strength: (measured strength of each mass number (m/z)) × ($\sqrt{m}$)

Radical strength represents a value determined by multiplying the measured strength of each mass number (m/z)) by $\sqrt{m}$ to correct the mass dependence of QMS measurement sensitivity.

m: the mass number (molecular weight) of measured neutral particles

z: the charge state of particles ionized within the QMS

(Relative peak intensity of radical density of deposition gas)

× (source power density squared)

*Source power density: area

(Relative peak intensity of radical density of deposition gas)

× (source power density squared)

*Source power density: volume

## INTERNATIONAL SEARCH REPORT

| International application No. |
| --- |
| **PCT/JP2025/007085** |

### A. CLASSIFICATION OF SUBJECT MATTER

*H01L 21/3065*(2006.01)i; *H01L 21/768*(2006.01)i; *H01L 21/3205*(2006.01)i; *H01L 23/522*(2006.01)i
FI: H01L21/302 105A; H01L21/88 J

According to International Patent Classification (IPC) or to both national classification and IPC

### B. FIELDS SEARCHED

Minimum documentation searched (classification system followed by classification symbols)

H01L21/3065; H01L21/768; H01L21/3205; H01L23/522

Documentation searched other than minimum documentation to the extent that such documents are included in the fields searched

Published examined utility model applications of Japan 1922-1996
Published unexamined utility model applications of Japan 1971-2025
Registered utility model specifications of Japan 1996-2025
Published registered utility model applications of Japan 1994-2025

Electronic data base consulted during the international search (name of data base and, where practicable, search terms used)

### C. DOCUMENTS CONSIDERED TO BE RELEVANT

| Category* | Citation of document, with indication, where appropriate, of the relevant passages | Relevant to claim No. |
| --- | --- | --- |
| X | JP 2017-518645 A (L'AIR LIQUIDE, SOCIETE ANONYME POUR L'ETUDE ET L'EXPLOITATION DES PROCEDES GEORGES CLAUDE) 06 July 2017 (2017-07-06) paragraphs [0003], [0013], [0022]-[0024], [0040]-[0045], [0057], [0059], [0071], fig. 1 | 1, 3-7, 10-12 |
| A | | 8, 9 |
| X | JP 2011-517848 A (APPLIED MATERIALS, INCORPORATED) 16 June 2011 (2011-06-16) paragraphs [0001]-[0002], [0027]-[0035], [0039]-[0040], [0060], fig. 4, 12 | 1, 2, 5, 10-12 |
| A | | 8, 9 |
| A | WO 2018/186364 A1 (KANTO DENKA KOGYO CO., LTD.) 11 October 2018 (2018-10-11) entire text, all drawings | 1-12 |

☐ Further documents are listed in the continuation of Box C.      ☑ See patent family annex.

| | |
| --- | --- |
| * Special categories of cited documents: | "T" later document published after the international filing date or priority date and not in conflict with the application but cited to understand the principle or theory underlying the invention |
| "A" document defining the general state of the art which is not considered to be of particular relevance | |
| "D" document cited by the applicant in the international application | "X" document of particular relevance; the claimed invention cannot be considered novel or cannot be considered to involve an inventive step when the document is taken alone |
| "E" earlier application or patent but published on or after the international filing date | |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search | Date of mailing of the international search report |
| --- | --- |
| **25 April 2025** | **13 May 2025** |

| Name and mailing address of the ISA/JP | Authorized officer |
| --- | --- |
| **Japan Patent Office (ISA/JP)** **3-4-3 Kasumigaseki, Chiyoda-ku, Tokyo 100-8915** **Japan** | |
| | Telephone No. |

Form PCT/ISA/210 (second sheet) (July 2022)

## INTERNATIONAL SEARCH REPORT
### Information on patent family members

International application No.

**PCT/JP2025/007085**

| Patent document cited in search report | | | Publication date (day/month/year) | Patent family member(s) | Publication date (day/month/year) |
|---|---|---|---|---|---|
| JP | 2017-518645 | A | 06 July 2017 | US 2017/0103901 A1<br>paragraphs [0004], [0014], [0024]-[0030], [0112], [0122]-[0126], [0138], [0140], [0152], fig. 1<br>WO 2015/194178 A1<br>EP 3158579 A1<br>KR 10-2017-0020434 A<br>CN 106663624 A | |
| JP | 2011-517848 | A | 16 June 2011 | US 2008/0153311 A1<br>paragraphs [0002]-[0005], [0041]-[0049], [0053]-[0054], [0072], fig. 4, 12<br>WO 2009/111395 A2<br>KR 10-2010-0135243 A<br>CN 101981659 A | |
| WO | 2018/186364 | A1 | 11 October 2018 | US 2020/0234962 A1<br>entire text, all drawings<br>EP 3608945 A1<br>KR 10-2019-0132625 A<br>CN 110546742 A | |

Form PCT/ISA/210 (patent family annex) (July 2022)

**REFERENCES CITED IN THE DESCRIPTION**

**Patent documents cited in the description**

- WO 2022074708 A1